# EUROPÄISCHE PATENTSCHRIFT

(11) **EP 3 084 340 B1**
(45) Veröffentlichungstag und Bekanntmachung des Hinweises auf die Patenterteilung: **21.02.2018**
(21) Anmeldenummer: 14818948.3
(22) Anmeldetag: 17.12.2014
(51) Int. Cl.: F42B 3/12

(54) **VERFAHREN ZUR HERSTELLUNG VON ELEKTRISCHEN AUSLÖSEELEMENTEN FÜR PYROTECHNISCHE GEGENSTÄNDE**
METHOD FOR PRODUCING ELECTRIC TRIGGER ELEMENTS FOR PYROTECHNIC ARTICLES
PROCÉDÉ DE FABRICATION D'ÉLÉMENTS DÉCLENCHEURS ÉLECTRIQUES POUR OBJETS PYROTECHNIQUES

(30) Priorität: 19.12.2013 DE 102013022323
(43) Veröffentlichungstag der Anmeldung: 26.10.2016
(73) Patentinhaber: RUAG Ammotec GmbH, 90765 Fürth (DE)
(72) Erfinder: WINTER, Andreas, 90768 Fürth (DE); ULRICH, Georg, 90768 Fürth (DE)
(74) Vertreter: Schmid, Nils T.F.
(86) Internationale Anmeldenummer: PCT/EP2014/078163
(87) Internationale Veröffentlichungsnummer: WO 2015/091612

(56) Entgegenhaltungen:
- WO-A1-02/057704
- DE-A1- 10 240 053
- US-A- 4 840 122

## Beschreibung

Die Erfindung betrifft ein Verfahren zur Herstellung von elektrischen Auslöseelementen für pyrotechnische Gegenstände wie Zünder oder Anzünder. Ein solches Verfahren ist aus DE 102 40 053 A1 bekannt. Elektrische Auslöseelemente dienen dazu, einen Primärexplosivstoff als erstes Glied einer Zünd- oder Anzündkette zu initiieren. Dazu wird die entstehende Wärme genutzt, die ein stromdurchflossener Widerstand abgibt. Der Primärexplosivstoff befindet sich in direktem Kontakt zum elektrischen Widerstand und wird durch Erreichen seiner Verpuffungstemperatur initiiert. Der elektrische Widerstand kann z.B. in Form eines Drahtes ausgeführt sein.

Das Herstellungsverfahren bezieht sich auf eine spezielle Form von Anzündelementen bei denen der elektrische Widerstand durch einen dünnen Metallfilm auf einer isolierenden Substratfläche gebildet wird. Derartige Auslöselemente sind bereits seit vielen Jahren gebräuchlich. Die Widerstandsschicht aus einem Metall mit hohem spezifischem Widerstand wird dabei durch einen Physical Vapour Deposition-Prozess (PVD) auf das Substrat (z.B. Keramik oder Glas) aufgebracht und gegebenenfalls abseits der vorgesehenen wohldefinierten Widerstandsfläche durch eine weitere Schicht aus einem Material mit hoher elektrischer Leitfähigkeit verstärkt. Die Geometrie der Widerstandsfläche richtet sich nach den Anforderungen der Anwendung insbesondere in Bezug auf Widerstandswert und Initiierungscharakteristik (z.B. erforderliche Stromstärke). Bei gängigen Herstellungsverfahren wird die Form der Widerstandsfläche (deren Dicke durch die Schichtdicke des Metallfilm gegeben ist) durch Lasermaterialbearbeitung an jedem einzelnen Bauteil erzeugt.

Durch die Einwirkung der hohen Laserleistung während der Materialbearbeitung können an den Rändern des Laserschnitts unerwünschte Materialveränderungen auftreten. Diese Materialänderungen (sowohl geometrischer als auch substantieller Art) wirken sich negativ auf die Initiierungs-Charakteristiken der Widerstandsschicht aus. Außerdem ist die einzelne Bearbeitung jedes Auslöseelements sehr zeitaufwändig.

Die Erfindung hat sich die Aufgabe gestellt ein neues Verfahren zur Herstellung von Initialelemente basierend auf PVD-Schichten anzugeben, das eine saubere Ausgestaltung der Ränder der Widerstandsschichten zulässt. Außerdem war es wünschenswert, die Herstellkosten zu reduzieren.

Erfindungsgemäß wird die Aufgabe gelöst, in dem zuerst photolithografisch ein Lack auf das Substrat aufgebracht wird. Dieser verhindert eine Beschichtung des Substrats in einem großflächigen Bereich, aber lässt einen in seiner Breite genau definierten Bereich der Substratoberfläche frei. Anschließend wird der PVD-Prozess auf Lack und Substrat durchgeführt. Dadurch wird eine elektrisch leitfähige Schicht zwischen den beiden Anschlusspolen des Auslöseelements hergestellt. Der Lack wird im Folgenden vom Substrat abgelöst, so dass man elektrisch nicht leitfähiges Substrat und einen in seiner Breite genau definierten Widerstandsbereich erhält, durch den später der Strom von einem Anschlusspol zum anderen fließen kann. Während des PVD-Prozesses wird die Dicke der Widerstandsschicht bereits eingestellt. Um die Länge ebenso genau zu erzeugen, wird erneut ein photolithografischer Prozess durchgeführt und ein genau definierter Bereich des Widerstandsstreifens mit Lack abgedeckt. Anschließend wird die gesamte Substratoberfläche mit einer relativ dicken Schicht gut leitfähigen Metalls überzogen (z.B. galvanische Vergoldung). Die Aufbringung des Metalls wird so gestaltet, dass in Bereichen die vom ersten Photolithographieprozess blankes Substrat aufweisen, kein Metall haftet. Anschließend wird der Lack vom zweiten Photolithografieprozess wieder abgelöst. Es bleibt ein durch den Photolack genau definierter Bereich übrig, der nur von der Schicht aus Metall mit hohem spezifischen Widerstand gebildet wird. Der erste Photolithografieprozess definiert die Breite der Widerstandsschicht und sorgt für Isolation in den umliegenden Gebieten, der zweite Prozess definiert die Länge und die zweite Schicht sorgt für gute elektrische Leitfähigkeit und gute Kontaktierung an den Anschlusspolen. Der PVD-Prozess selbst legt die Dicke der Widerstandsschicht fest. Zur genauen Einstellung des elektrischen Widerstands kann die PVD-Schicht ursprünglich zu dick ausgeführt werden und durch schrittweises Abtragen die Dicke verringert und damit der Widerstand genau eingestellt werden.

Die Erfindung betrifft:
- ein Verfahren zur Herstellung von elektrischen Auslöseelementen für pyrotechnische Gegenstände, bei dem in einer ersten Stufe
   a) photolithografisch ein Lack auf ein nicht elektrisch leitfähiges Substrat aufgebracht,
   b) mittels eines PVD-Prozesses ein leitfähiges Material in einer Schichtdicke von 0,02 µm bis 8,0 µm und mit einem spezifischen Widerstand von 0,1 Ω*mm bis 5,0 Ω*mm auf Lack und Substrat aufgebracht und
   c) der Lack vom Substrat abgelöst wird sowie in einer zweiten Stufe
   d) erneut ein photolithografischer Prozess durchgeführt wird, bei dem ein genau definierter Bereich des Widerstandsstreifens mit Photolack abgedeckt,
   e) die gesamte Substratoberfläche mit einer 0,1 µm bis 20 µm dicken Schicht eines Metalls mit einem spezifischen Widerstand von 0,01 Ω*mm bis 0,1 Ω*mm überzogen wird, wobei die Aufbringung des Metalls so gestaltet wird, dass in Bereichen die vom ersten Photolithographieprozess blankes Substrat aufweisen, kein Metall haftet und
   f) der Lack vom zweiten Photolithografieprozess wieder abgelöst wird;
- ein Verfahren, bei dem durch den Photolithografieprozess in der ersten Stufe die Breite der Widerstandsschicht definiert und für Isolation in den umliegenden Gebieten gesorgt wird;
- ein Verfahren, bei dem durch den Photolithografieprozess in der zweiten Stufe die Länge der Widerstandsschicht definiert wird;
- ein Verfahren, bei dem durch den PVD-Prozess ein leitfähiges Material in einer Schichtdicke von 0,02µm bis 8,0µm und einem spezifischer Widerstand von 0,1Ω*mm bis 5,0Ω*mm aufgebracht sowie im Schritt b) die Dicke der Widerstandsschicht festgelegt wird;
- ein Verfahren, bei dem die im Schritt b) aufgebrachte Schicht in einer den gewünschten Widerstandswert überschreitenden Dicke ausgeführt und durch schrittweises Abtragen die Dicke verringert sowie damit der Widerstand genau eingestellt wird;
- ein Verfahren, bei dem für den Fall, dass keine Verstärkung der Kontaktflächen durch zusätzliche gut leitende Schichten erforderlich ist, die gesamte Widerstandsgeometrie mit einer Fotomaske in einem einzigen Lithografieprozess realisiert wird;
- ein Verfahren, bei dem gegebenenfalls im Schritt e) eine gut elektrisch leitfähige Schicht aufgebracht wird;
- die Verwendung des Verfahrens zur Herstellung von pyrotechnischen Auslöseelementen und damit
- die photolithografische Erzeugung von Widerstandsschichten mit genau definierter Geometrie auf nichtleitendem Substrat,
- die Festlegung von Länge und Breite der Widerstandsschicht durch Nutzung von Photomasken zur gezielten Aushärtung von Photolack und
- Anwendung des beschriebenen Herstellverfahrens auf pyrotechnischen Auslöseelementen

Die besonderen Vorteile dieses Verfahrens liegen darin, dass sehr genau definierte Kanten des Widerstandsfilms entstehen und das Material über die gesamte Widerstandsfläche homogen ist (keine Materialveränderungen durch punktuelle Wärmeeinwirkung wie bei der Laserbearbeitung). Außerdem kann über Photomasken der Widerstand bei sehr vielen Auslöseelementen gleichzeitig aufgebracht werden und die Teile müssen im Fertigungsprozess erst zu einem späteren Zeitpunkt vereinzelt werden, was den Prozess schneller und kostengünstiger macht als herkömmliche Verfahren.

## Patentansprüche

1. Verfahren zur Herstellung von elektrischen Auslöseelementen für pyrotechnische Gegenstände, **dadurch gekennzeichnet, dass** in einer ersten Stufe
a) photolithografisch ein Lack auf ein nicht elektrisch leitfähiges Substrat aufgebracht,
b) mittels eines PVD-Prozesses ein leitfähiges Material in einer Schichtdicke von 0,02 µm bis 8,0 µm und mit einem spezifischen Widerstand von 0,1 Ω*mm bis 5,0 Ω*mm auf Lack und Substrat aufgebracht und
c) der Lack vom Substrat abgelöst wird sowie in einer zweiten Stufe
d) erneut ein photolithografischer Prozess durchgeführt wird, bei dem ein genau definierter Bereich des Widerstandsstreifens mit Photolack abgedeckt,
e) die gesamte Substratoberfläche mit einer 0,1 µm bis 20 µm dicken Schicht eines Metalls mit einem spezifischen Widerstand von 0,01 Ω*mm bis 0,1 Ω*mm überzogen wird, wobei die Aufbringung des Metalls so gestaltet wird, dass in Bereichen die vom ersten Photolithographieprozess blankes Substrat aufweisen, kein Metall haftet und
f) der Lack vom zweiten Photolithografieprozess wieder abgelöst wird.

2. Verfahren nach Anspruch 1, **dadurch gekennzeichnet, dass** durch den Photolithografieprozess in der ersten Stufe die Breite der Widerstandsschicht definiert und für Isolation in den umliegenden Gebieten gesorgt wird.

3. Verfahren nach Anspruch 1, **dadurch gekennzeichnet, dass** durch den Photolithografieprozess in der zweiten Stufe die Länge der Widerstandsschicht definiert wird.

4. Verfahren nach Anspruch 1 oder 2, **dadurch gekennzeichnet, dass** durch den PVD-Prozess im Schritt b) die Dicke der Widerstandsschicht festgelegt wird.

5. Verfahren nach Anspruch 1 bis 4, **dadurch gekennzeichnet, dass** die im Schritt b) aufgebrachte Schicht in einer den gewünschten Widerstandswert überschreitenden Dicke ausgeführt und durch schrittweises Abtragen die Dicke verringert sowie damit der Widerstand genau eingestellt wird.

6. Verfahren nach Anspruch 1 bis 4, **dadurch gekennzeichnet, dass** für den Fall, das keine Verstärkung der Kontaktflächen durch zusätzliche gut leitende Schichten erforderlich ist, die gesamte Widerstandsgeometrie mit einer Fotomaske in einem einzigen Lithografieprozess realisiert wird.

7. Verfahren nach Anspruch 1 bis 6, **dadurch gekennzeichnet, dass** im Schritt e) eine gut elektrisch leitende Schicht aufgebracht wird.

8. Verwendung des Verfahrens nach Anspruch 1 bis 7 zur Herstellung von pyrotechnischen Auslöseelementen.

## Claims

1. A method for manufacturing electrical trigger elements for pyrotechnic objects, **characterized in that**, in a first stage,
a) a lacquer is photolithographically applied to a non-electrically conductive substrate,
b) a PVD process is used to apply a conductive material in a layer thickness of 0.02 µm to 8.0 µm and with a specific resistance of 0.1 Ω*mm to 5.0 Ω*mm onto the lacquer and substrate, and
c) the lacquer is dissolved from the substrate,
and in a second stage,
d) a photolithographic process is again executed, in which a precisely defined area of the resistance strip is covered with photoresist,
e) the entire substrate surface is coated with a 0.1 µm to 20 µm thick layer of a metal having a specific resistance of 0.01 Ω*mm to 0.1 Ω*mm, wherein the metal is applied in such a way that no metal adheres in areas having blank substrate from the first photolithographic process, and
f) the lacquer from the second photolithographic process is again dissolved.

2. The method according to claim 1, **characterized in that**, in the first stage, the photolithographic process defines the width of the resistance layer and provides for insulation in the surrounding areas.

3. The method according to claim 1, **characterized in that**, in the second stage, the photolithographic process defines the length of the resistance layer.

4. The method according to claim 1 or 2, **characterized in that**, in step b), the PVD process determines the thickness of the resistance layer.

5. The method according to claims 1 to 4, **characterized in that** the layer applied in step b) is designed with a thickness exceeding the desired resistance value, and that the thickness is diminished via incremental removal, so that the resistance is thereby precisely set.

6. The method according to claims 1 to 4, **characterized in that**, if the contact surfaces need not be reinforced with additional readily conductive layers, the entire resistance geometry is realized with a photomask in a single lithographic process.

7. The method according to claims 1 to 6, **characterized in that**, in step e), a readily electrically conductive layer is applied.

8. Use of the method according to claims 1 to 7 for manufacturing pyrotechnic trigger elements.

## Revendications

1. Procédé pour la fabrication d'éléments de déclenchement électriques pour des objets pyrotechniques, **caractérisé en ce que** dans une première phase
a) une laque est appliquée de manière photolithographique sur un substrat électro-conducteur,
b) un matériau conducteur est appliqué au moyen d'un processus à dépôt physique en phase vapeur (DPV) dans une épaisseur de couche de 0,02 µm à 8,0 µm et avec une résistance spécifique de 0,1 Ω*mm à 5,0 Ω*mm sur une laque et un substrat, et
c) la laque est séparée du substrat,
ainsi que dans une deuxième phase
d) un processus photolithographique est à nouveau exécuté pour lequel une zone précisément définie de la bande résistive est recouverte de résine photosensible,
e) toute la surface de substrat est revêtue d'une couche d'un métal d'une épaisseur de 0,1 µm à 20 µm avec une résistance spécifique de 0,01 Ω*mm à 0,1 Ω*mm, l'application du métal prenant une forme telle que dans des zones qui comportent un substrat nu du premier processus de photolithographie, aucun métal n'adhère, et
f) la laque est à nouveau séparée par le deuxième processus de lithophotographie.

2. Procédé selon la revendication 1, **caractérisé en ce que** le processus de photolithographie définit dans la première phase la largeur de la couche de résistance et veille à l'isolation dans les zones environnantes.

3. Procédé selon la revendication 1, **caractérisé en ce que** la longueur de la couche de résistance est définie dans la deuxième phase par le processus de photolithographie.

4. Procédé selon la revendication 1 ou 2, **caractérisé en ce que** l'épaisseur de la couche de résistance est définie par le processus DPV dans l'étape b).

5. Procédé selon les revendications 1 à 4, **caractérisé en ce que** la couche appliquée dans l'étape b) est exécutée dans une épaisseur dépassant la valeur de résistance souhaitée et l'épaisseur est réduite par enlèvement progressif de telle sorte que la résistance est de ce fait établie de façon précise.

6. Procédé selon les revendications 1 à 4, **caractérisé en ce qu'**au cas où aucun renforcement des surfaces de contact n'est nécessaire par des couches supplémentaires bonnes conductrices, toute la géométrie de résistance est réalisée avec un photomasque dans un processus lithographique unique.

7. Procédé selon les revendications 1 à 6, **caractérisé en ce que** dans l'étape e), une couche bonne électro-conductrice est appliquée.

8. Utilisation du procédé selon les revendications 1 à 7 pour fabriquer des éléments de déclenchement pyrotechniques.
